# EUROPÄISCHE PATENTSCHRIFT

(11) **EP 3 144 435 B1**
(45) Veröffentlichungstag und Bekanntmachung des Hinweises auf die Patenterteilung: **23.10.2019**
(21) Anmeldenummer: 16001890.9
(22) Anmeldetag: 30.08.2016
(51) Int. Cl.: E03C 1/05, H03K 17/96, F16K 31/46

(54) **VERFAHREN ZUM BETRIEB EINER SANITÄRARMATUR UND SANITÄRARMATUR**
METHOD FOR OPERATING A SANITARY FITTING AND SANITARY FITTING
PROCÉDÉ DÉSTINÉ AU FONCTIONNEMENT D'UNE ROBINETTERIE ET ROBINETTERIE

(30) Priorität: 17.09.2015 DE 102015011811
(43) Veröffentlichungstag der Anmeldung: 22.03.2017
(73) Patentinhaber: Grohe AG, 58675 Hemer (DE)
(72) Erfinder: Mielke, Achim, 32457 Porta Westfalica (DE); Hamer, Felix, 58644 Iserlohn (DE)

(56) Entgegenhaltungen:
- WO-A1-01/20204
- DE-A1-102006 062 182
- US-A- 6 000 429

## Beschreibung

Die vorliegende Erfindung betrifft ein Verfahren zum Betrieb einer Sanitärarmatur sowie eine Sanitärarmatur, die der Zapfung eines Fluids dient. Solche Sanitärarmaturen werden regelmäßig in Verbindung mit Spülbecken, Waschbecken, Duschen und/oder Badewannen verwendet.

Aus dem Stand der Technik sind Sanitärarmaturen bekannt, bei denen die Zapfung bzw. Abgabe des Fluids (Wasser) durch Berührung eines Berührungssensors aktivierbar ist. Nachteilig an solchen Sanitärarmaturen ist, dass auch bei deren Reinigung und /oder Wartung eine ungewollte Aktivierung der Fluidabgabe durch das Berühren des Berührungssensors erfolgen kann, wodurch ein hoher bzw. unerwünschter Fluidverbrauch entsteht. Zur Vermeidung dieses Problems könnte bei derartigen Sanitärarmaturen zeitweise eine Deaktivierung des Berührungssensors vorgenommen werden, wobei eine Unterbrechung der Energieversorgung der Sanitärarmatur und/oder zusätzlich zu diesem Zweck vorgesehene Schalter unterhalb der Sanitärarmatur, beispielsweise an einer Untertischsteuerung der Sanitärarmatur, eingesetzt werden könnten. Eine solche vorübergehende Deaktivierung des Berührungssensors zur Reinigung / Wartung der Sanitärarmatur ist allerdings aufwendig und/oder kompliziert.

Die US 6 000 429 A offenbart eine Sanitärarmatur, bei der Infrarotsensoren zur Steuerung eines Wasserflusses zu Reinigungszwecken mittels einer Fernbedienung deaktivierbar sind. Weiterhin offenbart die WO 01/20204 A1 eine Sanitärarmatur mit Berührungssensoren zur automatischen Steuerung der Sanitärarmatur, wobei die Berührungssensoren mit einem separaten elektronischen Schalter oder einem zusätzlichen Berührungssensor deaktivierbar sind, um eine manuelle Steuerung der Sanitärarmatur zu ermöglichen. Zudem offenbart die DE 10 2006 062 182 A1 eine Sanitärarmatur mit berührungslosen Sensoren, wobei die berührungslosen Sensoren durch eine Handbewegung für Wartungszwecke abschaltbar sind.

Aufgabe der Erfindung ist daher, die mit Bezug auf den Stand der Technik geschilderten Probleme zumindest teilweise zu lösen und insbesondere ein Verfahren zum Betrieb (bzw. zeitweisen und bedarfsgerechten Inaktivierung) einer Sanitärarmatur sowie eine Sanitärarmatur anzugeben, die sich durch eine einfache Deaktivierbarkeit des Berührungssensors auszeichnen.

Diese Aufgaben werden gelöst mit einem Verfahren und einer Vorrichtung gemäß den Merkmalen der unabhängigen Patentansprüche. Weitere vorteilhafte Ausgestaltungen der Erfindung sind in den abhängig formulierten Patentansprüchen angegeben. Es ist darauf hinzuweisen, dass die in den abhängig formulierten Patentansprüchen einzeln aufgeführten Merkmale in beliebiger technologisch sinnvoller Weise miteinander kombiniert werden können und weitere Ausgestaltungen der Erfindung definieren. Darüber hinaus werden die in den Patentansprüchen angegebenen Merkmale in der Beschreibung näher präzisiert und erläutert, wobei weitere bevorzugte Ausgestaltungen der Erfindung dargestellt werden.

Hierzu trägt ein Verfahren zum Betrieb einer Sanitärarmatur bei, wobei die Sanitärarmatur ein Gehäuse mit einem Auslauf und einen Berührungssensor aufweist, wobei in einem Berührungsmodus der Sanitärarmatur durch Berührung des Berührungssensors eine Zapfung eines Fluids aktivierbar ist und wobei eine Deaktivierung des Berührungsmodus erfolgt, wenn der Berührungssensors für eine Dauer von mindestens 3 Sekunden berührt wird.

Die Sanitärarmatur dient insbesondere der bedarfsgerechten Bereitstellung eines Fluids, beispielsweise Wasser. Bei dem Fluid kann es sich auch um ein Mischwasser handeln, das durch die Sanitärarmatur aus einem Kaltwasser mit einer Kaltwassertemperatur von 0 °C (Celsius) bis 40 °C und einem Warmwasser mit einer Warmwassertemperatur von 40 °C bis 80 °C gemischt wird. Hierzu kann die Sanitärarmatur beispielsweise ein Mischventil oder ein Thermostatventil aufweisen. Diese können insbesondere über ein Stellglied, wie zum Beispiel einem Hebel oder dergleichen, der Sanitärarmatur bedient werden. Solche Sanitärarmaturen werden regelmäßig im Zusammenhang mit Spülbecken, Waschbecken, Duschen und/oder Badewannen verwendet. Die Sanitärarmatur weist ein Gehäuse mit einem Auslauf und einem Berührungssensor auf. Das Gehäuse und/oder der Auslauf können zumindest teilweise aus einem Kunststoff und/oder Metall, wie zum Beispiel Messing, bestehen.

Durch Berührung des Berührungssensors, bei dem es sich insbesondere um einen kapazitiven Sensor handeln kann, kann die Abgabe von Fluid aus der Sanitärarmatur aktiviert werden, wenn sich die Sanitärarmatur in einem Berührungsmodus befindet. Insbesondere zum Zwecke der Reinigung und/oder der Wartung der Sanitärarmatur kann der Berührungsmodus deaktiviert werden, indem der Berührungssensor für eine Dauer von mindestens 3 Sekunden, bevorzugt mindestens 6 Sekunden, berührt wird. Somit kann der Berührungsmodus durch besonders langes Kontaktieren des Berührungssensors durch einen Benutzer ausgeschaltet bzw. inaktiv gesetzt werden, ohne dass zusätzliche Schalter und/oder gar eine Unterbrechung der Energieversorgung der Sanitärarmatur erforderlich sind. Durch die Deaktivierung des Berührungsmodus werden insbesondere der Berührungssensor und/oder eine Steuerung der Sanitärarmatur derart eingestellt beziehungsweise deaktiviert, dass eine Aktivierung der Zapfung des Fluids über den Berührungssensor für eine bestimmte Zeitdauer nicht möglich ist. Gleichwohl könnte die Abgabe von Fluid durch mechanische Stellglieder weiterhin vorgenommen werden.

Anzumerken ist, dass in dem Zeitraum des "deaktivierten Berührungsmodus" die Sensitivität des Berührungssensors ausgeschaltet sein kann, dies ist jedoch nicht zwingend erforderlich. So könnte eine Berührung des Berührungssensors durch einen Benutzer sehr wohl auch in diesem Zeitraum erfasst werden können, jedoch wird dann die Abgabe von Fluid nicht veranlasst. Dies soll erst dann wieder gestattet sein, wenn spezifische Voraussetzungen erfüllt sind und der Berührungsmodus wieder aktiv ist.

Zudem ist es vorteilhaft, wenn die Deaktivierung des Berührungsmodus für eine (vorgegebene) Dauer von mindestens 2 Minuten erfolgt. Hierdurch wird sichergestellt, dass der Berührungsmodus für eine Reinigung der Sanitärarmatur ausreichend lange deaktiviert wird.

Darüber hinaus ist es vorteilhaft, wenn die Deaktivierung des Berührungsmodus durch ein Auslaufen des Fluids aus dem Auslauf bestätigt wird. Das heißt mit anderen Worten, dass die Sanitärarmatur mit Ende der Deaktivierung durch Zeitablauf und/oder mit Beginn der erneuten Aktivierung des Berührungsmodus eine (geringe) Menge des Fluids abgibt, ggf. mit einem vorgebbaren Strahlbild. Hierdurch kann beispielsweise auf zusätzliche Signalleuchten zur Anzeige der Deaktivierung des Berührungsmodus verzichtet werden.

Des Weiteren ist es in diesem Zusammenhang vorteilhaft, wenn das Auslaufen des Fluids maximal für 2 Sekunden erfolgt. Das Auslaufen des Fluids erfolgt bevorzugt maximal 1 Sekunde oder besonders bevorzugt maximal 0,5 Sekunden. Hierdurch kann ein unnötiger Verbrauch des Fluids verhindert werden.

Zudem ist es vorteilhaft, wenn der Berührungsmodus nach seiner Deaktivierung nach Ablauf einer Zeitspanne automatisch wieder aktiviert wird. Insbesondere bedarf es also keiner weiteren Aktionen oder Betätigungsvorgänge durch einen Benutzer, wieder den Berührungsmodus einzuschalten. Die Zeitspanne kann dabei beispielsweise eine Dauer von 1 bis 3 Minuten betragen.

Es kann auch vorteilhaft sein, wenn der Berührungsmodus nach seiner Deaktivierung durch Berührung des Berührungssensors für eine Dauer von mindestens 3 Sekunden wieder aktiviert wird. Mit anderen Worten heißt das beispielsweise auch, dass der Berührungsmodus zeitlich vor dem regulär vorgegebenen Zeitablauf mittels einer besonders gestalteten Betätigung bzw. Kontaktierung des Berührungssensors wieder eingeschaltet wird. Die Aktivierung des Berührungsmodus erfolgt bevorzugt durch eine Berührung des Berührungssensors für eine Dauer von mindestens 6 Sekunden.

Vorzugsweise wird (auch) die (vorzeitige und durch den Benutzer ausgelöste) Aktivierung des Berührungsmodus durch ein Auslaufen des Fluids aus dem Auslauf bestätigt. Die Menge oder die Art und Weise der Abgabe von Fluid kann hierfür angepasst werden, z. B. ebenso wie oben bereits beschrieben.

Einem weiteren Aspekt folgend wird auch eine Sanitärarmatur vorgeschlagen, die ein Gehäuse mit einem Auslauf und einen Berührungssensor zur Aktivierung einer Zapfung eines Fluids aufweist, wobei ein Berührungsmodus der Sanitärarmatur durch eine Steuerung steuerbar bzw. einstellbar ist, die zur Durchführung des hier beschriebenen Verfahren eingerichtet und vorgesehen ist. Bei der Steuerung kann es sich beispielsweise um einen Mikroprozessor handeln, der datenleitend und/oder elektrizitätsleitend mit dem Berührungssensor und/oder einem Ventil zur Steuerung eines Auslaufs des Fluids aus dem Auslauf verbunden ist. Für weitere Einzelheiten wird auch auf die vorstehende Beschreibung des Verfahrens verwiesen.

Die Erfindung sowie das technische Umfeld werden nachfolgend anhand der Figur näher erläutert. Es ist darauf hinzuweisen, dass die Figur eine besonders bevorzugte Ausführungsvariante der Erfindung zeigt, diese jedoch nicht darauf beschränkt ist.

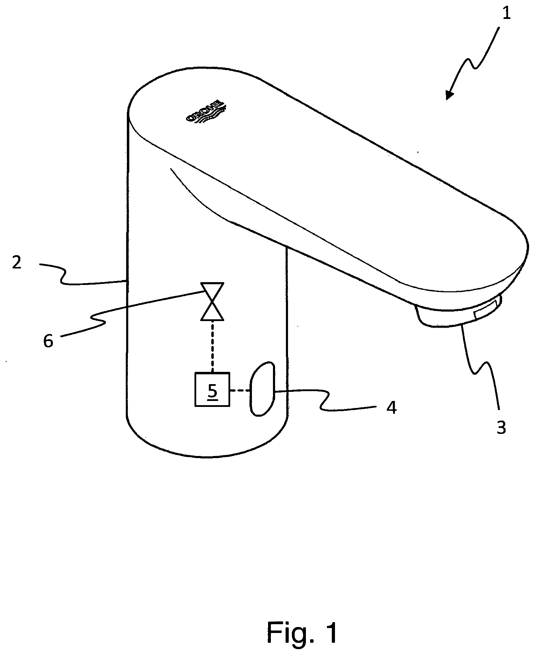

Die Fig. 1 zeigt schematisch und beispielhaft eine Sanitärarmatur 1 mit einem Gehäuse 2 und einem Auslauf 3. An dem Gehäuse 2 der Sanitärarmatur 1 ist ein Berührungssensor 4 angeordnet, der datenleiten beziehungsweise elektrizitätsleitend mit einer Steuerung 5 der Sanitärarmatur 1 verbunden ist. Die Steuerung 5 ist zur Durchführung des hier vorgeschlagenen Verfahrens eingerichtet und vorgesehen, sodass durch die Steuerung 5 bei Berührung des Berührungssensors 4 für eine Dauer von mindestens 3 Sekunden eine Deaktivierung eines Berührungsmodus der Sanitärarmatur 1 erfolgen kann. Während der Deaktivierung des Berührungsmodus erfolgt trotz einer (üblichen bzw. kurzzeitigen) Berührung des Berührungssensors 4, beispielsweise beim Reinigen der Sanitärarmatur 1, keine Abgabe von Fluid (hier insbesondere Wasser). Hierzu ist die Steuerung 5 datenleitend mit einem Ventil 6 verbunden, das während der Deaktivierung des Berührungsmodus durch die Steuerung 5 geschlossen wird. Das Ventil 6 ist in einer hier nicht gezeigten Leitung angeordnet, über die das Fluid durch die Sanitärarmatur 1 zu dem Auslauf 3 leitbar ist.

Die vorgeschlagene Sanitärarmatur zeichnet sich insbesondere durch einen Betätigungsmodus aus, der besonders komfortabel deaktivierbar ist.

### Bezugszeichenliste

- 1: Sanitärarmatur
- 2: Gehäuse
- 3: Auslauf
- 4: Berührungssensor
- 5: Steuerung
- 6: Ventil

## Patentansprüche

1. Verfahren zum Betrieb einer Sanitärarmatur (1), wobei die Sanitärarmatur (1) ein Gehäuse (2) mit einem Auslauf (3) und einen Berührungssensor (4) aufweist, wobei in einem Berührungsmodus der Sanitärarmatur (1) durch Berührung des Berührungssensors (4) eine Zapfung eines Fluids aktivierbar ist, **dadurch gekennzeichnet, dass** eine Deaktivierung des Berührungsmodus erfolgt, wenn der Berührungssensors (4) für eine Dauer von mindestens 3 Sekunden berührt wird.

2. Verfahren nach Patentanspruch 1, wobei die Deaktivierung des Berührungsmodus für eine Dauer von mindestens 2 Minuten erfolgt.

3. Verfahren nach einem der vorhergehenden Patentansprüche, wobei die Deaktivierung des Berührungsmodus durch ein Auslaufen des Fluids aus dem Auslauf bestätigt wird.

4. Verfahren nach Patentanspruch 3, wobei das Auslaufen des Fluids maximal für 2 Sekunden erfolgt.

5. Verfahren nach einem der vorhergehenden Patentansprüche, wobei der Berührungsmodus nach seiner Deaktivierung nach Ablauf einer Zeitspanne automatisch wieder aktiviert wird.

6. Verfahren nach einem der vorhergehenden Patentansprüche, wobei der Berührungsmodus nach seiner Deaktivierung durch Berührung des Berührungssensors (4) für eine Dauer von mindestens 3 Sekunden wieder aktiviert wird.

7. Verfahren nach Patentanspruch 5 oder 6, wobei die Aktivierung des Berührungsmodus durch ein Auslaufen des Fluids aus dem Auslauf (3) bestätigt wird.

8. Verfahren nach Patentanspruch 7, wobei das Auslaufen des Fluids maximal für 2 Sekunden erfolgt.

9. Sanitärarmatur (1), aufweisend ein Gehäuse (2) mit einem Auslauf (3) und einen Berührungssensor (4) zur Aktivierung einer Zapfung eines Fluids, wobei ein Berührungsmodus der Sanitärarmatur (1) durch eine Steuerung (5) steuerbar ist, **dadurch gekennzeichnet, dass** die Steuerung (5) zur Durchführung des Verfahrens nach einem der vorhergehenden Patentansprüche eingerichtet und vorgesehen ist.

## Claims

1. A method for operating a sanitary fitting (1), wherein the sanitary fitting (1) comprises a housing (2) having an outlet (3) and a contact sensor (4), wherein a tapping of a fluid can be activated in a contact mode of the sanitary fitting (1) by touching the contact sensor (4), **characterized in that** a deactivation of the contact mode occurs if the contact sensor (4) is touched for a duration of at least 3 seconds.

2. The method according to Claim 1, wherein the deactivation of the contact mode occurs for a duration of at least 2 minutes.

3. The method according to any one of the preceding claims, wherein the deactivation of the contact mode is confirmed by a discharge of fluid from the outlet.

4. The method according to Claim 3, wherein the discharge of the fluid occurs for 2 seconds at most.

5. The method according to any one of the preceding claims, wherein the contact mode, after the deactivation thereof, is automatically reactivated after the passing of a time interval.

6. The method according to any one of the preceding claims, wherein the contact mode, after the deactivation thereof by touching the contact sensor (4), is reactivated for a duration of at least 3 seconds.

7. The method according to Claim 5 or 6, wherein the activation of the contact mode is confirmed by a discharge of fluid from the outlet (3).

8. The method according to Claim 7, wherein the discharge of the fluid occurs for 2 seconds at most.

9. A sanitary fitting (1) comprising a housing (2) having an outlet (3) and a contact sensor (4) for activating a tapping of a fluid, wherein a contact mode of the sanitary fitting (1) can be controlled by a control (5), **characterized in that** the control (5) is configured and provided for carrying out the method according to any one of the preceding claims.

## Revendications

1. Procédé opératoire pour une robinetterie sanitaire (1), la robinetterie sanitaire (1) comportant un corps (2) muni d'un bec (3) et un capteur de contact (4), dans un mode tactile de la robinetterie sanitaire (1), en touchant le capteur de contact (4), un soutirage d'un fluide étant activable, **caractérisé en ce qu'**il s'effectue une désactivation du mode de contact lorsqu'on touche le capteur de contact (4) sur une durée d'au moins 3 secondes.

2. Procédé selon la revendication 1, la désactivation du mode tactile s'effectuant pour une durée d'au moins 2 minutes.

3. Procédé selon l'une quelconque des revendications précédentes, la désactivation du mode tactile étant confirmée par un écoulement du fluide hors du bec.

4. Procédé selon la revendication 3, l'écoulement du fluide s'effectuant pour un maximum de 2 secondes.

5. Procédé selon l'une quelconque des revendications précédentes, après sa désactivation, le mode tactile étant automatiquement réactivé après écoulement d'une période.

6. Procédé selon l'une quelconque des revendications précédentes, après sa désactivation, le mode tactile étant réactivé en touchant le capteur de contact (4) pour une durée d'au moins 3 secondes.

7. Procédé selon la revendication 5 ou 6, l'activation du mode tactile étant confirmée par un écoulement du fluide hors du bec (3).

8. Procédé selon la revendication 7, l'écoulement du fluide s'effectuant pour un maximum de 2 secondes.

9. Robinetterie sanitaire (1) comportant un corps (2), muni d'un bec (3) et d'un capteur de contact (4), destiné à activer le soutirage d'un fluide, un mode tactile de la robinetterie sanitaire (1) étant susceptible d'être commandé par un système de commande (5), **caractérisé en ce que** le système de commande (5) est aménagé et prévu pour réaliser le procédé selon l'une quelconque des revendications précédentes.
